(19) Europäisches Patentamt
European Patent Office
Office européen des brevets

(11) **EP 4 538 890 A1**

(12) **EUROPEAN PATENT APPLICATION**
published in accordance with Art. 153(4) EPC

(43) Date of publication:
**16.04.2025 Bulletin 2025/16**

(21) Application number: **23826122.6**

(22) Date of filing: **02.06.2023**

(51) International Patent Classification (IPC):
**G06F 11/10** (2006.01)  **H03M 13/11** (2006.01)

(52) Cooperative Patent Classification (CPC):
**G06F 11/10; G11C 29/42; H03M 13/11**

(86) International application number:
**PCT/CN2023/098056**

(87) International publication number:
**WO 2023/246473 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.06.2022 CN 202210723134**

(71) Applicant: **Huawei Technologies Co., Ltd.
Shenzhen, Guangdong 518129 (CN)**

(72) Inventors:
• **XING, Jiongyue
Shenzhen, Guangdong 518129 (CN)**

• **WU, Tingyi
Shenzhen, Guangdong 518129 (CN)**
• **HAN, Yung Hsiang
Shenzhen, Guangdong 518129 (CN)**
• **BAI, Bo
Shenzhen, Guangdong 518129 (CN)**
• **ZHANG, Gong
Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **DECODING METHOD, CHIP AND RELATED APPARATUS**

(57) This application provides a decoding method, a chip, and a related apparatus. A threshold determining mechanism is introduced, so that a controller chip can simultaneously perform calculation of a quantity of check equations that are not met by a bit and a bit flipping process, to reduce a decoding delay of the controller chip and increase a decoding throughput. In addition, an algorithm for calculating, by the controller chip, the quantity of check equations that are not met by each bit is optimized, to reduce a probability that a correct bit is incorrectly flipped, so as to reduce an error floor of decoding.

S1001: Read a first bit sequence, and obtain a check matrix H of the first bit sequence, where the first bit sequence includes n pieces of bit data

S1002: Obtain a first syndrome S1 based on the first bit sequence and the check matrix H; when the first syndrome S1 is not an all-0 value, determine, based on the first bit sequence and the first syndrome S1, a first quantity of check equations that are in the check matrix H and that are not met by each piece of bit data in the first bit sequence; and when the first quantity of check equations that are in the check matrix H and that are not met by first bit data in the first bit sequence is greater than or equal to a first threshold T1, flip the first bit data to obtain a second bit sequence

S1003: After the second bit sequence is obtained, obtain a second syndrome S2 based on the second bit sequence and the check matrix H; and when the second syndrome S2 is not an all-0 value, obtain, based on the second bit sequence, the second syndrome S2, and a first regular term, a second quantity of check equations that are in the check matrix H and that are not met by each piece of bit data in the second bit sequence, where the first regular term is less than or equal to 0

S1004: When the second quantity of check equations that are in the check matrix H and that are not met by second bit data in the second bit sequence is greater than or equal to a second threshold T2, flip the second bit data to obtain a third bit sequence; after the third bit sequence is obtained, obtain a third syndrome S3 based on the third bit sequence and the check matrix H; and when the third syndrome S3 is an all-0 value, output the third bit sequence

FIG. 10

EP 4 538 890 A1

**Description**

This application claims priority to Chinese Patent Application No. 202210723134.0, filed with the China National Intellectual Property Administration on June 24, 2022 and entitled "DECODING METHOD, CHIP, AND RELATED APPARATUS", which is incorporated herein by reference in its entirety.

**TECHNICAL FIELD**

This application relates to the field of chip technologies, and in particular, to a decoding method, a chip, and a related apparatus.

**BACKGROUND**

A solid state drive (solid state drive, SSD) is a hard disk made of a solid state electronic storage chip array, and the SSD includes a control unit and a storage unit. A storage medium used by the solid state disk is a flash memory chip (for example, a NAND chip). Advantages of the solid state disk are fast starting, fast reading, no need for addressing, and direct data reading without affecting reading time.

Performance of an SSD storage device is usually measured based on a reading speed of the SSD storage device on a NAND chip and a service life of the device. The reading speed depends on a decoding speed (or a throughput) of an error correction algorithm, and the service life of the device depends on extreme decoding performance of the error correction algorithm. How to improve a reading speed and a service life of an SSD is an urgent problem to be resolved.

**SUMMARY**

This application provides a decoding method, a chip, and a related apparatus, to reduce a probability that a correct bit is incorrectly flipped, reduce a decoding delay of a controller chip, and increase a decoding throughput.

According to a first aspect, this application provides a decoding method. The method includes: reading a first bit sequence, and obtaining a check matrix H of the first bit sequence, where the first bit sequence includes n pieces of bit data; obtaining a first syndrome S1 in a first iteration process based on the first bit sequence and the check matrix H; when the first syndrome S1 is not an all-0 value, determining, by a chip based on the first bit sequence and the first syndrome S1, a first quantity of check equations that are in the check matrix H and that are not met by each piece of bit data in the first bit sequence; when the first quantity of check equations that are in the check matrix H and that are not met by first bit data in the first bit sequence is greater than or equal to a first threshold T1, flipping the first bit data to obtain a second bit sequence; in a second iteration process, after the second bit sequence is obtained, obtaining a second syndrome S2 based on the second bit sequence and the check matrix H; when the second syndrome S2 is not an all-0 value, obtaining, based on the second bit sequence, the second syndrome S2, and a first regular term, a second quantity of check equations that are in the check matrix H and that are not met by each piece of bit data in the second bit sequence, where the first regular term is less than or equal to 0; when the second quantity of check equations that are in the check matrix H and that are not met by second bit data in the second bit sequence is greater than or equal to a first threshold T2, flipping the second bit data to obtain a third bit sequence; after the third bit sequence is obtained, obtaining a third syndrome S3 based on the third bit sequence and the check matrix H; and when the third syndrome S3 is an all-0 value, outputting the third bit sequence.

In this way, the foregoing process is repeated until the syndrome is an all-0 value or a maximum quantity of iterations is reached.

According to the method in the first aspect, an algorithm for calculating, by a controller chip, a quantity of check equations that are not met by each bit is optimized, to reduce a probability that a correct bit is incorrectly flipped, so as to reduce an error floor of decoding. In addition, a threshold determining mechanism is introduced, so that the controller chip can simultaneously perform calculation of a quantity of check equations that are not met by a bit and a bit flipping process, to reduce a decoding delay of the controller chip and increase a decoding throughput. In addition, a random sequence generator is proposed to limit a flipping probability of a bit that meets a flipping condition. This reduces occurrences of a case in which a same bit falls into an infinite cycle due to repeated flipping. The decoding delay of the controller chip is reduced, and the decoding throughput is increased.

With reference to the first aspect, in a possible implementation, the method further includes: in a third iteration process, when the third syndrome S3 is not an all-0 value, obtaining, based on the third bit sequence, the second syndrome S2, and a second regular term, a third quantity of check equations that are in the check matrix H and that are not met by each piece of bit data in the third bit sequence, where the second regular term is less than or equal to 0; when the third quantity of check equations that are in the check matrix H and that are not met by third bit data in the third bit sequence is greater than or equal to a third threshold T3, flipping the third bit data to obtain a fourth bit sequence; after the fourth bit sequence is obtained, obtaining a fourth syndrome S4 based on the fourth bit sequence and the check matrix H; and when the fourth syndrome S4 is an all-0 value, outputting the third bit sequence. In this way, the foregoing process is repeated until the syndrome is an all-0 value or a maximum quantity of iterations is reached.

With reference to the first aspect, in a possible implementation, the first regular term is less than 0 when a location of the first bit data in the first bit sequence is the same as a location of the second bit data in the second bit sequence. In this way, an algorithm for calculating, by the controller chip, a quantity of check equations that are not met by each bit is optimized, to reduce a probability that a correct bit is incorrectly flipped, so as to reduce an error floor of decoding.

Optionally, the first regular term is equal to 0 when the location of the first bit data in the first bit sequence is different from the location of the second bit data in the second bit sequence.

With reference to the first aspect, in a possible implementation, when a location of the first bit data in the first bit sequence, a location of the second bit data in the second bit sequence, and a location of the third bit data in the third bit sequence are the same, the second regular term is equal to the first regular term, and the second regular term is less than 0. In this way, if a same piece of bit data is continuously flipped, when a quantity of check equations that are not met by the bit data is calculated, a regular term less than 0 is added, to reduce a probability of the bit data being repeatedly flipped.

With reference to the first aspect, in a possible implementation, a value of the second regular term is 0 when the location of the second bit data in the second bit sequence is different from the location of the third bit data in the third bit sequence.

With reference to the first aspect, in a possible implementation, when the first bit data is flipped, the method further includes: when the first quantity of check equations that are in the check matrix H and that are not met by fourth bit data in the first bit sequence is greater than or equal to the first threshold T1, flipping the fourth bit data to obtain the second bit sequence. In this way, a threshold determining mechanism is introduced, so that the controller chip can simultaneously perform calculation of a quantity of check equations that are not met by a bit and a bit flipping process, to reduce a decoding delay of the controller chip and increase a decoding throughput.

With reference to the first aspect, in a possible implementation, the first threshold T1 is determined based on the check matrix H.

With reference to the first aspect, in a possible implementation, after the second bit sequence is obtained, and before the second bit data is flipped, the method further includes: obtaining, based on the first quantity of check equations that are in the check matrix H and that are not met by each piece of bit data and a preset maximum quantity of check equations that are in the check matrix H and that are not met by each piece of bit data, a fourth quantity of check equations that are in the check matrix H and that are not met by each piece of bit data; and determining, by the chip, that a largest value of the first quantity of check equations that are in the check matrix H and that are not met by each piece of bit data and the fourth quantity of check equations that are in the check matrix H and that are not met by each piece of bit data is the second threshold T2. In this way, a threshold T needs to be updated after flipping is performed each time.

With reference to the first aspect, in a possible implementation, the fourth quantity of check equations that are in the check matrix H and that are not met by each piece of bit data is determined based on $E_j^1 = d_{vj} + 1 - E_j$, where $E_j^1$ indicates the fourth quantity of check equations that are in the check matrix H and that are not met by each piece of bit data, $d_{vj}$ indicates the preset maximum quantity of check equations that are in the check matrix H and that are not met by each piece of bit data, and $E_j$ indicates the first quantity of check equations that are in the check matrix H and that are not met by each piece of bit data.

With reference to the first aspect, in a possible implementation, the flipping the first bit data specifically includes: obtaining a first digital sequence based on a first probability value and a first random sequence generator, where a quantity of elements included in the first digital sequence is the same as a quantity of pieces of flipped bit data in the first bit sequence, a value of an element in the first digital sequence is 0 or 1, and a proportion of elements whose values are 1 in the first digital sequence is the first probability value; and flipping the first bit data when a value of an element corresponding to a location that is in the first digital sequence and that corresponds to a location of the first bit data in the first bit sequence is 1. The random sequence generator is proposed to limit a flipping probability of a bit that meets a flipping condition. This reduces occurrences of a case in which a same bit falls into an infinite cycle due to repeated flipping. The decoding delay of the controller chip is reduced, and the decoding throughput is increased.

With reference to the first aspect, in a possible implementation, the first bit sequence is output when the first syndrome S1 is an all-0 value.

With reference to the first aspect, in a possible implementation, the second bit sequence is output when the second syndrome S2 is an all-0 value.

According to a second aspect, this application provides a chip. The chip includes a processing circuit and an interface circuit, the interface circuit is configured to receive code instructions and transmit the code instructions to the processing circuit, and the processing circuit is configured to run the code instructions to perform the decoding method according to any possible implementation of any one of the foregoing aspects.

According to a third aspect, this application provides a decoding apparatus. The decoding apparatus includes a chip and a memory. The memory is configured to store a first bit sequence. The chip is configured to read the first bit sequence from the memory, to perform the decoding method according to any possible implementation of any one of the foregoing aspects.

According to a fourth aspect, this application provides a computer-readable storage medium. The computer-readable storage medium stores instructions, and when the instructions are run on a chip, the chip is enabled to perform the decoding method according to any possible implementation of any one of the foregoing aspects.

According to a fifth aspect, this application provides a computer program product. When the computer program product is executed by a chip, the chip is enabled to perform the decoding method according to any possible implementation of any one of the foregoing aspects.

## BRIEF DESCRIPTION OF DRAWINGS

FIG. 1 is a diagram of a method of a multi-stage decoding algorithm according to an embodiment of this application;
FIG. 2 is a principle diagram of a GDBF algorithm according to an embodiment of this application;
FIG. 3 is a diagram of a Tanner graph according to an embodiment of this application;
FIG. 4 is a diagram according to an embodiment of this application;
FIG. 5 shows a NAND medium-based SSD storage system according to an embodiment of this application;
FIG. 6 is a diagram of an error correction process of an SSD controller chip according to an embodiment of this application;
FIG. 7 is a diagram of an LDPC code decoding method according to an embodiment of this application;
FIG. 8 is a diagram of a 0-1 digital sequence generated by a random sequence generator according to an embodiment of this application;
FIG. 9 is a diagram of another method of a multi-stage decoding algorithm according to an embodiment of this application; and
FIG. 10 is a diagram of a decoding method according to an embodiment of this application.

## DESCRIPTION OF EMBODIMENTS

The technical solutions according to embodiments of this application are clearly and completely described in the following with reference to the accompanying drawings. In the descriptions of embodiments of this application, unless otherwise stated, "/" represents "or". For example, A/B may represent A or B. In this specification, "and/or" merely describes an association relationship between associated objects and represents that three relationships may exist. For example, A and/or B may represent the following three cases: Only A exists, both A and B exist, and only B exists. In addition, in the descriptions of embodiments of this application, "a plurality of" means two or more than two.

The following terms "first" and "second" are merely intended for a purpose of description, and shall not be understood as implying or implying relative importance or implicitly indicating a quantity of indicated technical features. Therefore, a feature limited by "first" or "second" may explicitly or implicitly include one or more of the features. In the descriptions of embodiments of this application, unless otherwise specified, "a plurality of" means two or more.

To ensure a throughput and a service life, a current controller chip usually uses a multi-stage decoding algorithm.

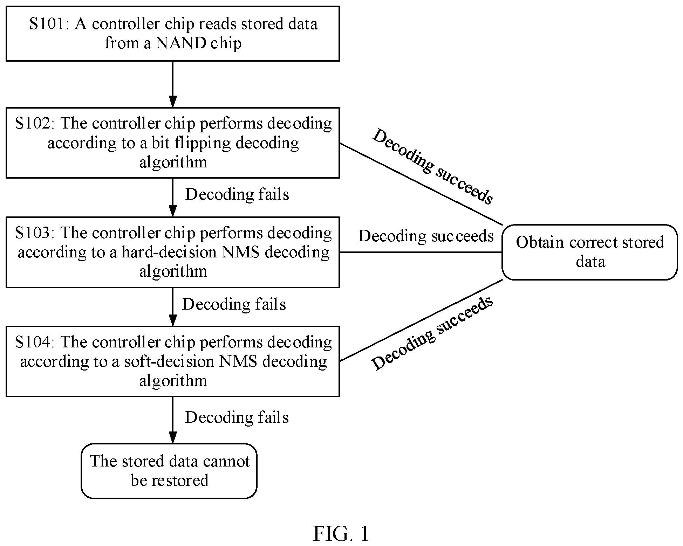

FIG. 1 is an example of a diagram of a method of a multi-stage decoding algorithm.

For example, the multi-stage decoding algorithm may be: A first-stage decoding algorithm is a bit flipping (bit flipping, BF) decoding algorithm, a second-stage decoding algorithm is a hard-decision normalized min sum (normalized min sum, NMS) decoding algorithm, and a third-stage decoding algorithm is a soft-decision NMS decoding algorithm.

S101: A controller chip reads stored data from a NAND chip.

S102: The controller chip performs decoding according to the bit flipping decoding algorithm.

The controller chip performs decoding according to the bit flipping decoding algorithm; and after decoding succeeds, the controller chip outputs correct stored data, and decoding ends.

If the controller chip fails to perform decoding according to the bit flipping decoding algorithm, the controller chip performs a next-stage decoding algorithm.

S103: The controller chip performs decoding according to the hard-decision NMS decoding algorithm.

The controller chip performs decoding according to the hard-decision NMS decoding algorithm; and after decoding succeeds, the controller chip outputs correct stored data, and decoding ends.

If the controller chip fails to perform decoding according to the hard-decision NMS decoding algorithm, the controller chip performs a next-stage decoding algorithm.

S104: The controller chip performs decoding according to the soft-decision NMS decoding algorithm.

The controller chip performs decoding according to the soft-decision NMS decoding algorithm; and after decoding succeeds, the controller chip outputs correct stored data, and decoding ends.

If the controller chip fails to perform decoding according to the soft-decision NMS decoding algorithm, decoding ends, and the controller chip cannot restore correct stored data.

For the foregoing multi-stage decoding algorithms, an error probability of the NAND medium is low at an initial use stage. To increase a throughput, the controller chip preferentially uses the bit flipping decoding algorithm for decoding. The bit flipping decoding algorithm has a high decoding speed, but has a limited error correction capability. With an increase of a quantity of erase cycles and leakage of charges of a cell in a data storage process, the error probability of the NAND medium is increased. In this case, a possibility of a decoding failure by using the bit flipping decoding algorithm is also increased, and correct stored data cannot be restored. To prolong a service life of an SSD device, the controller chip starts the hard-decision NMS decoding algorithm that has a stronger error correction capability but a longer decoding delay and the soft-decision NMS decoding algorithm.

Therefore, a reading speed of the SSD mainly depends on the bit flipping decoding algorithm. In other words, the decoding speed of the bit flipping decoding algorithm is improved. The service life of the SSD mainly depends on time for switching from the bit flipping decoding algorithm to the hard-decision NMS decoding algorithm and the soft-decision NMS decoding algorithm. In other words, the error correction capability of the bit flipping decoding algorithm needs to be improved. A stronger error correction capability of the bit flipping decoding algorithm indicates shorter time for using the hard-decision NMS decoding algorithm and the soft-decision NMS decoding algorithm and a longer service life of the SSD.

The bit flipping decoding algorithm may be a gradient descent bit flipping (gradient descent bit flipping, GDBF) algorithm.

The following describes an implementation principle of the GDBF algorithm.

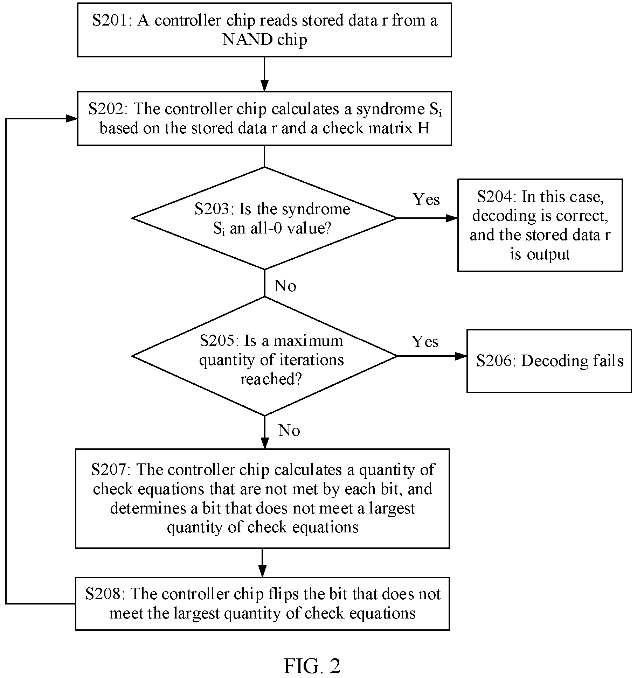

FIG. 2 is an example of a principle diagram of the GDBF algorithm.

The GDBF algorithm includes the following steps.

S201: The controller chip reads stored data r from the NAND chip.

First, the controller chip reads the stored data r, where the stored data r may be a bit sequence whose length is n, and the stored data r may be represented as (r0, r1, r2, r3, r4, r5, ..., m-1).

S202: The controller chip calculates a syndrome Si based on the stored data r and a check matrix H.

S203: Is the syndrome Si an all-0 value?

If the syndrome Si is the all-0 value, S204 is performed. In this case, decoding is correct, and the stored data r is output. If the syndrome Si is not the all-0 value, S205 is performed.

S205: Is a maximum quantity of iterations reached?

If the maximum quantity of iterations is reached, S206 is performed. In this case, decoding fails, and the decoding process ends. If the syndrome Si is not the all-0 value, S207 is performed.

The following describes how the controller chip calculates the syndrome Si.

The controller chip obtains the check matrix H of the stored data, where the check matrix is a matrix with m rows and n columns, an element in the check matrix is 0 or 1, and a length of the check matrix H is the same as a length of the stored data r. The check matrix H is a sparse matrix. In other words, in the check matrix, a quantity of non-zero elements is far less than a quantity of zero elements. Correct stored data c meets H*cT=0. After channel transmission, a correct bit sequence c is interfered by noise and the like, and a bit error is prone to be generated. Therefore, received information is r. In this case, H*rT=0 is no longer true. The bit error existing in r need to be found through decoding and corrected, until H*rT=0 is met or the set maximum quantity of iterations is reached. A value of H*rT may be understood as a syndrome.

A set of locations of elements 1 in an $i^{th}$ row of the check matrix may be represented as C(i), a degree of C(i) may be represented as $d_{ci}$, and $d_{ci}$ indicates a quantity of elements 1 in the $i^{th}$ row. A set of locations of elements 1 in a $j^{th}$ column of the check matrix may be represented as V(j), a degree of V(j) may be represented as $d_{vj}$, and $d_{vj}$ indicates a quantity of elements 1 in the $j^{th}$ column.

In a possible implementation, the controller chip may calculate a syndrome of the stored data r, and determine whether a value of the syndrome is an all-0 value. If the value of the syndrome is the all-0 value, decoding is correct, and the controller chip outputs correct decoding information. If the value of the syndrome is not the all-0 value, decoding is incorrect. If decoding is incorrect, the controller chip needs to determine a bit at which decoding is incorrect, and flip the bit. A specific flipping manner is: if a value of the bit is 0, changing 0 to 1; or if a value of the bit is 1, changing 1 to 0.

The controller chip may calculate a syndrome of each bit in the stored data r based on the check matrix H and the stored data r.

A formula for calculating the syndrome is shown in Formula (1).

$$Si = \sum_{j \in C(i)} \hat{r}_j \, mod2 \qquad \text{Formula (1)}$$

As shown in Formula (1), Si indicates a value of a syndrome of an $i^{th}$ bit in the stored data r, and a value of Si is 0 or 1. According to Formula (1), the controller chip may calculate the syndrome of each bit in the stored data r, and a syndrome of the stored data r may be represented as S (S0, S1, S2, S3, S4, ..., Sm-1). In a first calculation process, $\hat{r}_j$ is equal to $r_j$.

If S is an all-0 value, decoding is correct in this case, and the controller chip outputs decoding information. If S is not an all-0 value, decoding is incorrect in this case, and the controller chip needs to determine a location at which decoding is incorrect.

S207: The controller chip calculates a quantity of check equations that are not met by each bit, and determines a bit that does not meet a largest quantity of check equations.

S208: The controller chip flips the bit that does not meet the largest quantity of check equations.

When decoding is incorrect, the controller chip needs to determine a location at which decoding is incorrect. The location at which decoding is incorrect is the bit that does not meet the largest quantity of check equations.

The controller chip may determine the location at which decoding is incorrect based on the stored data r and the syndrome. The controller chip may calculate energy of each bit j, and may determine an energy value of each bit according to Formula (1). The energy value of each bit may also be referred to as the quantity of check equations that are not met by each bit.

$$E_j \triangleq r_j \oplus \hat{r}_j + \sum_{i \in V(j)} s_i \qquad \text{Formula (2)}$$

As shown in Formula (2), $E_j$ indicates the energy of the bit j, and a symbol "$\oplus$" indicates an exclusive OR operation. The energy of the bit j may be understood as a quantity of check equations that are not met by the bit j. A larger quantity of check equations that are not met by the bit j indicates higher unreliability of the bit, and a smaller quantity of check equations that are not met by the bit j indicates lower unreliability of the bit.

After determining the quantity of check equations that are not met by each bit j, the controller chip determines a bit j that does not meet a largest quantity of check equations. Then, the controller chip flips the bit according to Formula (3).

$$\hat{r}_j = \hat{r}_j \oplus 1 \quad \text{Formula (3)}$$

As shown in Formula (3), after the controller chip determines the bit j that does not meet the largest quantity of check equations, the controller chip flips the bit. In other words, if a value of the bit is 1, the value of the bit is flipped from 1 to 0. If a value of the bit is 0, the value of the bit is flipped from 1 to 1.

The location at which decoding is incorrect is determined based on S202 to S208. When the maximum quantity of iterations is reached, the decoding process is exited, and decoding fails in this case. Alternatively, when the value of the syndrome is an all-0 value, it indicates that decoding is correct in this case. In this case, decoding succeeds and ends, and the controller chip outputs a correct decoding result $\hat{r}_j$.

The following first describes in detail, with reference to a specific example, a principle of how to calculate a syndrome and how to calculate a quantity of check equations that are not met by each bit in the foregoing embodiments, so as to facilitate understanding of subsequent embodiments.

First, the controller chip reads the stored data r, where the stored data r may be a bit sequence whose length is n. Then, a low-density parity-check (low-density parity-check, LDPC) decoder may use the bit sequence as information from a $0^{th}$ variable node to a check node, or the LDPC decoder may determine information from a $0^{th}$ variable node to a check node based on the bit sequence.

In an iteration process, based on a Tanner graph, the LDPC decoder may first perform check node update for each check node. Performing check node update may be performing iteration on a check node, and performing iteration on the check node may be obtaining information transferred by the iterated check node to a variable node. Then, variable node update is performed for each variable node based on an iteration result of the check node. Performing variable node update may be performing iteration on a variable node. Performing iteration on the variable node may be obtaining information transferred by the iterated variable node to the check node. Then, check node update may be performed based on an update result of the variable node, and variable node update is performed based on an update result of the check node. Iteration is performed repeatedly a plurality of times, to meet an iteration termination condition.

After each time check node update and/or variable node update are/is performed, the LDPC decoder may determine the iteration termination condition based on a variable node updated each time and/or a check node updated each time. If it is determined, based on the variable node updated each time and/or the check node updated each time, that the iteration termination condition is met (for example, the syndrome is an all-0 value), the decoding process ends, and a decoding result is determined from a variable node and a check node in a last iteration. If the variable node updated each time and/or the check node updated each time do/does not meet the iteration termination condition, a next iteration process starts until a maximum quantity of iterations is reached.

Tanner proposes the concept of describing code words by using a graph model, so that a check matrix of an LDPC code is mapped to a bidirectional bipartite graph that is referred to as a Tanner graph. The LDPC code constructed by using the Tanner graph can significantly reduce decoding complexity through parallel decoding.

The Tanner graph is a bidirectional graph indicating an LDPC code. The Tanner graph includes two types of vertices: n codeword bit nodes (which may also be referred to as bit nodes), which separately correspond to columns of the check matrix; and m check equation vertices (which may also be referred to as check nodes), which separately correspond to rows of the check matrix. The Tanner graph may indicate a check matrix of the LDPC code. Each row of the check matrix indicates one check equation, and each column indicates one codeword bit. An element of 1 in the check matrix indicates that there is a connection edge between a bit node and a check node in the Tanner graph. The edge may be referred to as an adjacent edge of nodes at two ends, the nodes at the two ends of the adjacent edge may be referred to as adjacent nodes, and a quantity of adjacent edges of each node may be referred to as a degree of the node.

For example, the stored data $\hat{r}$ (which may also be referred to as a bit sequence $\hat{r}$) may be represented as (r0, r1, r2, r3, r4, r5, r6, r7, r8, r9). It is assumed that the bit sequence $\hat{r}$ is specifically (1, 0, 0, 0, 0, 0, 0, 0, 0, 0), and the check matrix H of the LDPC code is shown in Formula (4):

$$H = \begin{bmatrix} 1 & 1 & 1 & 0 & 0 & 1 & 1 & 0 & 0 & 1 \\ 1 & 0 & 1 & 0 & 1 & 1 & 0 & 1 & 1 & 0 \\ 0 & 0 & 1 & 1 & 1 & 0 & 1 & 0 & 1 & 1 \\ 0 & 1 & 0 & 1 & 1 & 1 & 0 & 1 & 0 & 1 \\ 1 & 1 & 0 & 1 & 0 & 0 & 1 & 1 & 1 & 0 \end{bmatrix} \quad \text{Formula (4)}$$

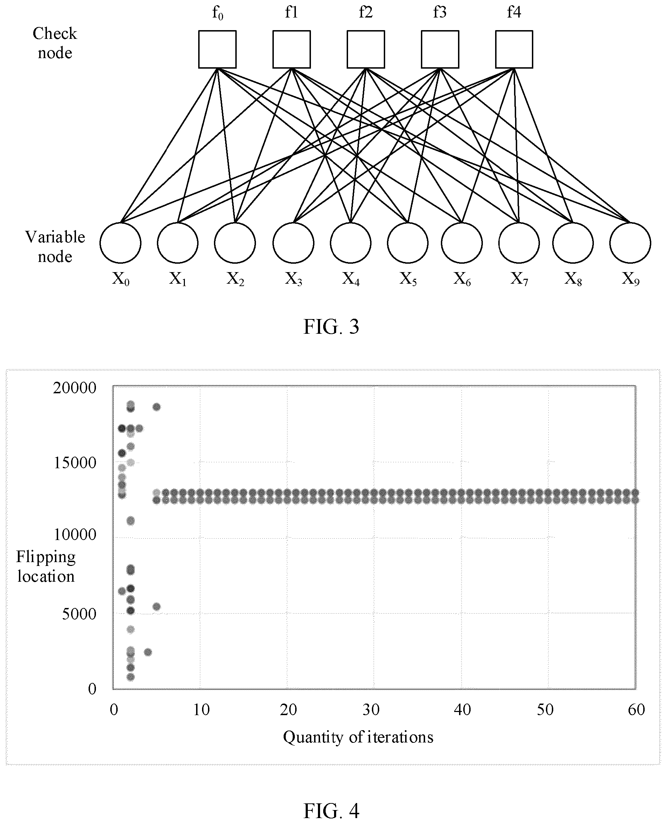

In this case, the bit sequence r definitely meets a system of linear equations H*rT=0. After channel transmission, a bit sequence r=(r0, r1, r2, r3, r4, r5, r6, r7, r8, r9) received by the LDPC decoder may include an error. Therefore, H*rT=0 is no longer true, a location of an existing bit error needs to be found based on a decoding method, and the bit error needs to be corrected. Refer to FIG. 3. FIG. 3 is a diagram of a Tanner graph according to an embodiment of this application. It can be learned from FIG. 3 that X0, X1, ..., and X9 are referred to as variable nodes, indicate 10 bits, and are unknown variables to be solved by the decoder. In the figure, f0, f1, f2, f3, and f4 are referred to as check nodes, and each indicate a check equation in a system of linear equations. An element of "1" in the check matrix H indicates a connection line between a variable node and a check node in the Tanner graph.

In a decoding iteration process, information is transferred between a variable node and a check node. In the Tanner graph, when there is a connection line between the variable node and the check node, information may be transferred between the variable node and the check node. The LDPC decoder may use a bit sequence Y as information from a 0th variable node to a check node, or the LDPC may determine information from a 0th variable node to a check node based on a bit sequence Y. In other words, a check node f0 may receive information transferred by variable nodes X0, X1, X2, X5, X6, and X9. Similarly, a check node f1 may receive information transferred by variable nodes X0, X2, X4, X5, X7, and X8; a check node f2 may receive information transferred by variable nodes X2, X3, X4, X6, X8, and X9; a check node f3 may receive information transferred by variable nodes X1, X3, X4, X5, X7, and X9; and a check node f4 may receive information transferred by variable nodes X0, X1, X3, X6, X7, and X8. After processing received information, each check node transfers information obtained through processing to a variable node adjacent to the check node. In other words, a variable node X0 may receive information transferred by check nodes f0, f1, and f4; a variable node X1 may receive information transferred by check nodes f0, f3, and f4; a variable node X2 may receive information transferred by check nodes f0, f1, and f2; a variable node X3 may receive information transferred by check nodes f2, f3, and f4; a variable node X4 may receive information transferred by check nodes f1, f2, and f3; a variable node X5 may receive information transferred by check nodes f0, f1, and f3; a variable node X6 may receive information transferred by check nodes f0, f2, and f4; a variable node X7 may receive information transferred by check nodes f1, f3, and f4; a variable node X8 may receive information transferred by check nodes f1, f2, and f4; and a variable node X9 may receive information transferred by check nodes f0, f2, and f3. Then, each variable node processes obtained information. Finally, decoding decision is performed on information obtained through processing. If a syndrome of the bit sequence is an all-0 value, decoding ends. If a syndrome of the bit sequence is not an all-0 value, iteration is performed repeatedly a plurality of times until a set maximum quantity of iterations is reached.

The following describes, with reference to the check equation shown in Formula (4) and the bit sequence r, how the controller chip obtains, through calculation, a syndrome and a quantity of check equations that are not met by each bit.

As shown in the check equation shown in Formula (4), based on the check equation shown in Formula (4), a set of locations of elements 1 in a 0th row of the check matrix H may be obtained, and may be represented as C(0)={0, 1, 2, 5, 6, 9}.

A set of locations of elements 1 in a 1st row of the check matrix H may be represented as C(1)={0, 2, 4, 5, 7, 8}.

A set of locations of elements 1 in a 2nd row of the check matrix H may be represented as C(2)={2, 3, 4, 6, 8, 9}.

A set of locations of elements 1 in a 3rd row of the check matrix H may be represented as C(3)={1, 3, 4, 5, 7, 9}.

A set of locations of elements 1 in a 4th row of the check matrix H may be represented as C(4)={0, 1, 3, 6, 7, 8}.

Each number in C(0), C(1), C(2), C(3), and C(4) indicates a location of an element 1 in each row of the check matrix H.

Based on C(0), C(1), C(2), C(3), and C(4), a quantity of elements 1 in each row of the check matrix H, namely, a degree of C(i), may be obtained, where the degree of C(i) may be represented as d ci.

Here, $d_{c(0)}=d_{c(1)}=d_{c(2)}=d_{c(3)}=d_{c(4)}=6$.

As shown in the check equation shown in Formula (4), based on the check equation shown in Formula (4), a set of locations of elements 1 in a 0th column of the check matrix H may be obtained, and may be represented as V(0)={0, 1, 4}.

A set of locations of elements 1 in a 1st column of the check matrix H may be represented as V(1)={0, 3, 4}.

A set of locations of elements 1 in a 2nd column of the check matrix H may be represented as V(2)={0, 1, 2}.

A set of locations of elements 1 in a 3rd column of the check matrix H may be represented as V(3)={2, 3, 4}.

A set of locations of elements 1 in a 4th column of the check matrix H may be represented as V(4)={1, 2, 3}.

A set of locations of elements 1 in a 5th column of the check matrix H may be represented as V(5)={0, 1, 3}.

A set of locations of elements 1 in a 6th column of the check matrix H may be represented as V(6)={0, 2, 4}.

A set of locations of elements 1 in a 7th column of the check matrix H may be represented as V(7)={0, 3, 4}.

A set of locations of elements 1 in an 8th column of the check matrix H may be represented as V(8)={1, 2, 4}.

A set of locations of elements 1 in a 9th column of the check matrix H may be represented as V(9)={0, 2, 3}.

Each number in V(0), V(1), V(2), V(3), V(4), V(5), V(6), V(7), V(8), and V(9) indicates a location of an element 1 in each column of the check matrix H.

Based on V(0), V(1), V(2), V(3), V(4), V(5), V(6), V(7), V(8), and V(9), a quantity of elements 1 in each column of the check matrix H, namely, a degree of V(j), may be obtained, where the degree of V(j) may be represented as $d_{vj}$. Here, $d_{vj}$ may also indicate a maximum quantity of check equations that are not met by a $j^{th}$ bit.

Here, $d_{v(0)}=d_{v(1)}=d_{v(2)}=d_{v(3)}=d_{v(4)}=d_{v(5)}=d_{v(6)}=d_{v(7)}=d_{v(8)}=d_{v(9)}=3$. It may be learned that a maximum quantity of check equations that are not met by each bit in the bit sequence $\hat{r}$ is 3.

It is assumed that the bit sequence $\hat{r}=(1,0,0,0,0,0,0,0,0,0)$. Based on the check equation H shown in Formula (4) and the bit sequence $\hat{r}$, a syndrome S may be obtained according to the formula $H*\hat{r}T$, or a syndrome S may be obtained according to Formula (1).

The following describes how the controller chip obtains the syndrome S according to Formula (1).

$$S0=\sum_{j\in C(0)}\hat{r}_j \bmod 2=(\hat{r}_0 + \hat{r}_1+\hat{r}_2 + \hat{r}_5 + \hat{r}_6 + \hat{r}_9)\bmod 2=(1+0+0+0+0+0)\bmod 2=1.$$

$$S1=\sum_{j\in C(1)}\hat{r}_j \bmod 2=(\hat{r}_0 + \hat{r}_2+\hat{r}_4 + \hat{r}_5 + \hat{r}_7 + \hat{r}_9)\bmod 2=(1+0+0+0+0+0)\bmod 2=1.$$

$$S2=\sum_{j\in C(2)}\hat{r}_j \bmod 2=(\hat{r}_2 + \hat{r}_3+\hat{r}_4 + \hat{r}_6 + \hat{r}_8 + \hat{r}_9)\bmod 2=(0+0+0+0+0+0)\bmod 2=0.$$

$$S3=\sum_{j\in C(3)}\hat{r}_j \bmod 2=(\hat{r}_1 + \hat{r}_3+\hat{r}_4 + \hat{r}_5 + \hat{r}_7 + \hat{r}_9)\bmod 2=(0+0+0+0+0+0)\bmod 2=0.$$

$$S4=\sum_{j\in C(4)}\hat{r}_j \bmod 2=(\hat{r}_0 + \hat{r}_1+\hat{r}_3 + \hat{r}_6 + \hat{r}_7 + \hat{r}_8)\bmod 2=(1+0+0+0+0+0)\bmod 2=1.$$

The syndrome S=(11001) may be obtained based on the check matrix H and the bit sequence $\hat{r}$. Because the syndrome S is not an all-0 value, there is an incorrect bit in the bit sequence $\hat{r}$, and the controller chip needs to find a location of the incorrect bit in the bit sequence $\hat{r}$, and flips the incorrect bit.

A method for determining the location of the incorrect bit is as follows: The controller chip separately calculates a quantity of check equations that are not met by each bit. In each bit, a bit that does not meet a largest quantity of check equations is the incorrect bit. Based on the check equation H shown in Formula (4), it may be determined that a quantity of elements 1 in each column is a maximum quantity of check equations that are not met by each bit. It may be learned that the maximum quantity of check equations that are not met by each bit is 3 or 4. However, in actual calculation, the quantity of check equations that are not met by each bit is less than or equal to 3 or less than or equal to 4.

The controller chip may calculate, according to Formula (2), the quantity of check equations that are not met by each bit.

A quantity of check equations that are not met by a 0th bit is: $E_0 \triangleq r_0 \oplus \hat{r}_0 + \sum_{i\in V(0)} s_i = 1\oplus 1+(S0+S1+S4)$ =0+1+1+1=3.

A quantity of check equations that are not met by a 1st bit is: $E_1 \triangleq r_1 \oplus \hat{r}_1 + \sum_{i\in V(1)} s_i = 1\oplus 1+(S0+S3+S4)$ =0+1+0+1=2.

A quantity of check equations that are not met by a 2nd bit is: $E_2 \triangleq r_2 \oplus \hat{r}_2 + \sum_{i\in V(2)} s_i = 1\oplus 1+(S0+S3+S4)$ =0+1+0+1=2.

A quantity of check equations that are not met by a 3rd bit is: $E_3 \triangleq r_3 \oplus \hat{r}_3 + \sum_{i\in V(3)} s_i = 1\oplus 1+(S2+S3+S4)$

=0+0+0+1=1.

A quantity of check equations that are not met by a 4th bit is: $E_4 \triangleq r_4 \oplus \hat{r}_4 + \sum_{i \in V(4)} s_i = 1 \oplus 1 + (S1+S2+S3)$ =0+1+0+0=1.

A quantity of check equations that are not met by a 5th bit is: $E_5 \triangleq r_5 \oplus \hat{r}_5 + \sum_{i \in V(5)} s_i = 1 \oplus 1 + (S0+S1+S3)$ =0+1+1+0=2.

A quantity of check equations that are not met by a 6th bit is: $E_6 \triangleq r_6 \oplus \hat{r}_6 + \sum_{i \in V(6)} s_i = 1 \oplus 1 + (S0+S3+S4)$ =0+1+0+1=2.

A quantity of check equations that are not met by a 7th bit is: $E_7 \triangleq r_{37} \oplus \hat{r}_7 + \sum_{i \in V(7)} s_i = 1 \oplus 1 + (S0+S3+S4)$ =0+1+0+1=2.

A quantity of check equations that are not met by an 8th bit is: $E_8 \triangleq r_8 \oplus \hat{r}_8 + \sum_{i \in V(8)} s_i = 1 \oplus 1 + (S1+S2+S4)$ =0+0+1+1=2.

A quantity of check equations that are not met by a 9th bit is: $E_9 \triangleq r_9 \oplus \hat{r}_9 + \sum_{i \oplus V(9)} s_i = 1 \oplus 1 + (S0+S2+S3)$ =0+1+0+0=1.

It can be learned from $E_0$ to $E_9$ that, the largest value is $E_0$, that is, the quantity of check equations that are not met by the 0th bit is the largest. The controller chip may determine that the 0th bit is a bit at which an error occurs. The controller chip may flip the 0th bit according to Formula (3), to obtain a flipped bit sequence, that is, change the 0th bit from "1" to "0", and the flipped bit sequence may be represented as r̂1=(0, 0, 0, 0, 0, 0, 0, 0, 0).

Based on the check matrix S shown in Formula (4) and the flipped bit sequence r̂1, the syndrome is calculated again. If the syndrome is an all-0 value, decoding is correct in this case, and the flipped bit sequence r̂1 is output. If the syndrome is not an all-0 value, a quantity of check equations that are not met by each bit in the flipped bit sequence r̂1 may be calculated based on the foregoing steps, and then the incorrect bit is found. Based on this method, if the syndrome is an all-0 value in an iteration process, decoding is correct in this case, and a flipped bit sequence is output. If the syndrome is not an all-0 value and a maximum quantity of iterations is reached in a subsequent iteration process, decoding ends in this case, and decoding fails.

Based on the foregoing analysis, it can be learned that the GDBF algorithm shown in FIG. 2 has the following defects.

Defect 1: As shown in FIG. 4, the GDBF algorithm may fall into an infinite cycle until a maximum quantity of iterations is reached. As a result, decoding fails. Specifically, in a bit flipping process, the controller chip may flip two correct bits, and flip two incorrect bits. In a next bit flipping process, the controller chip may flip the two correct bits again, and flip the two incorrect bits again. By analogy, the controller chip may repeatedly flip the two correct bits and the two incorrect bits for infinite times. As a result, decoding fails.

Defect 2: After the infinite cycle shown in Defect 1 occurs again, the GDBF algorithm has a high error floor. In addition, with a decrease of a raw bit error rate (raw bit error rate, RBER), an uncorrectable bit error rate (uncorrectable bit error rate, UBER) cannot be significantly increased.

Defect 3: In the GDBF algorithm shown in FIG. 2, only after a quantity of check equations that are not met by each bit is calculated, a bit at which decoding may be incorrect can be determined based on a bit that does not meet a largest quantity of check equations, and then the bit at which decoding may be incorrect is flipped. In other words, calculation of the quantity of check equations that are not met by each bit and the bit flipping process cannot be performed simultaneously. Consequently, a decoding delay is long, and a throughput is reduced.

Based on the foregoing analysis, embodiments of this application are mainly for first-stage decoding, namely, a bit flipping decoding algorithm. The bit flipping decoding algorithm is optimized to provide a high-performance and high-throughput bit flipping decoding algorithm, so as to prolong a service life of an SSD device.

The optimized bit flipping decoding algorithm mainly includes the following improvements.

Improvement 1: An algorithm for calculating, by the controller chip, a quantity of check equations that are not met by each bit is optimized, to reduce a probability that a correct bit is incorrectly flipped, so as to reduce an error floor of decoding.

Improvement 2: A threshold determining mechanism is introduced, so that the controller chip can simultaneously perform calculation of a quantity of check equations that are not met by a bit and a bit flipping process, to reduce a decoding delay of the controller chip and increase a decoding throughput.

Improvement 3: A random sequence generator is proposed to limit a flipping probability of a bit that meets a flipping condition. This reduces occurrences of a case in which a same bit falls into an infinite cycle due to repeated flipping. The decoding delay of the controller chip is reduced, and the decoding throughput is increased.

Specific descriptions of Improvement 1, Improvement 2, and Improvement 3 are described in detail in subsequent embodiments. Details are not described herein in this embodiment of this application.

Application scenarios of the present invention are various NAND medium-based SSD storage systems. A solution of the present invention serves a data error correction module on an SSD controller chip, to ensure reliability of a storage information reading process, prolong a service life of a storage device, and the like. This solution is applicable to an SSD product that uses a low-density parity-check (low-density parity-check, LDPC) code as an error-correcting code. The product includes but is not limited to devices such as a computer device, a mobile terminal, a high-performance server, and a data center. The high-performance server product may include a server product like OceanStor Dorado storage or OceanStor 5000F storage.

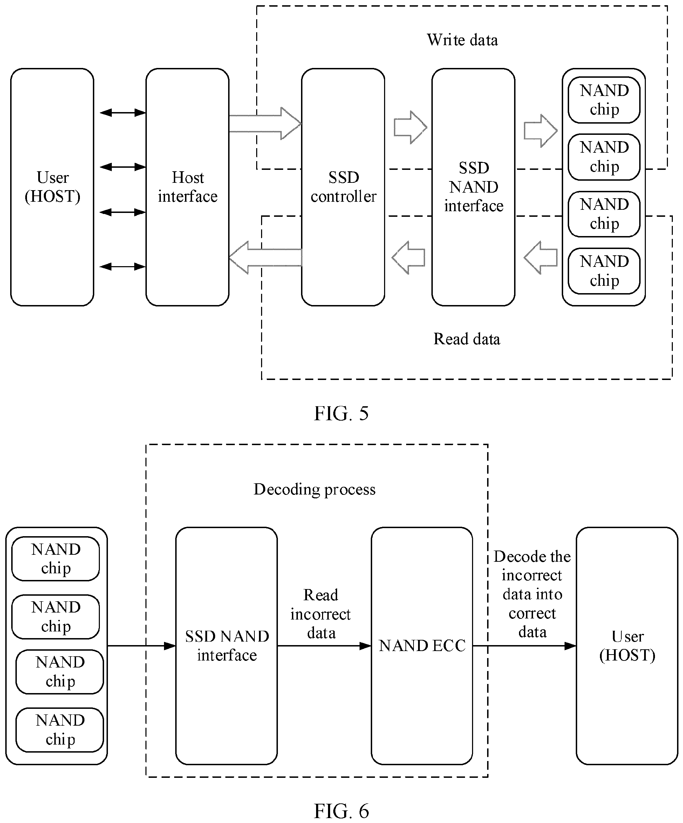

FIG. 5 shows an example of a NAND medium-based SSD storage system according to an embodiment of this application.

The storage system includes but is not limited to a host (host), a host interface, an SSD controller, an SSD NAND interface, and a plurality of NAND chips.

The NAND chip is a storage medium, and is a non-volatile memory.

The SSD NAND interface is configured to read data from or write data into a NAND chip.

The SSD controller is also referred to as a main control chip or a main control, and is mainly configured to read data from or write data into a NAND chip by controlling the SSD NAND interface.

A user (host) is configured to read or write data through the SSD controller.

As shown in FIG. 5, a user may transmit instructions and data through the host interface and the SSD controller, and the SSD controller is responsible for reading and writing data on a NAND chip through the SSD NAND interface. In other words, the user may read the data from the NAND chip through the host interface, the SSD controller, and the SSD NAND interface. The user may also write data to the NAND chip through the host interface, the SSD controller, and the SSD NAND interface.

FIG. 6 is an example of a diagram of an error correction process of an SSD controller chip.

The SSD controller chip reads data from a NAND chip through an SSD NAND interface. The read data may be incorrect. Therefore, to output correct data to a user, the SSD controller chip needs to perform decoding through a NAND error correcting code (NAND error correcting code, NAND ECC) module to restore the correct data. How the SSD controller chip performs error correcting code decoding to restore the correct data is described in detail in a subsequent embodiment. Details are not described herein in this embodiment of this application.

In the following embodiments of this application, the SSD controller chip may also be referred to as a controller chip for short.

The following describes an LDPC code decoding method according to an embodiment of this application.

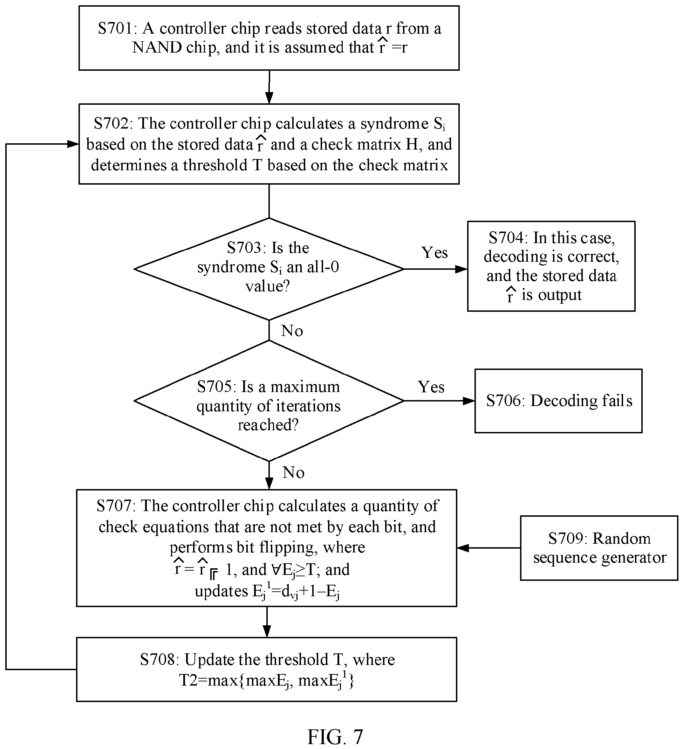

FIG. 7 is a diagram of an LDPC code decoding method according to an embodiment of this application.

S701: A controller chip reads stored data r from a NAND chip, and it is assumed that r̂=r.

First, the controller chip reads the stored data r from the NAND chip. The stored data r may be a bit sequence whose length is n, the stored data r may also be referred to as a bit sequence r, and the bit sequence r may be represented as (r0, r1, r2, r3, r4, r5, ..., rn-1). The controller chip obtains a check matrix H of the stored data, where the check matrix is a matrix with m rows and n columns, and an element in the check matrix is 0 or 1. The check matrix H is a sparse matrix. In other words, in the check matrix, a quantity of non-zero elements is far less than a quantity of zero elements. Correct data c meets $H * c^T = 0$. After channel transmission, the bit sequence r is interfered by noise and the like, and a bit error is prone to be generated. Therefore, received information is r̂. In this case, $H * r̂^T = 0$ is no longer true. The bit error existing in r need to be found through decoding.

Before a first iterative operation is performed, it is assumed that the bit sequence r̂=the bit sequence r.

S702: The controller chip calculates a syndrome Si based on the stored data r̂ and the check matrix H, and determines a threshold T based on the check matrix.

The controller chip may obtain, based on the check matrix H, a maximum quantity of check equations that are not met by each bit. In other words, in the check matrix H, a quantity of elements 1 in each column is the maximum quantity of check equations that are not met by each bit, which may also be referred to as a maximum degree of each bit. Each bit may also be referred to as a variable node, and therefore, the quantity of elements 1 in each column may also be referred to as a maximum quantity of check equations that are not met by the variable node or a maximum degree of the variable node.

$$T = \max\{d_{vj}, \forall j\} \qquad \text{Formula (5)}$$

As shown in Formula (5), T indicates a largest quantity in all quantities of check equations that are not met by bits, $d_{vj}$ indicates a degree of a $j^{th}$ bit, namely, a maximum quantity of check equations that are not met by the $j^{th}$ bit, or may be a quantity of elements 1 in a $j^{th}$ column of the check matrix H. In this way, after obtaining degrees of all bits, the controller chip selects a largest degree from the degrees of all bits as the threshold T. The threshold T is used by the controller chip to compare an actual quantity of check equations that are not met by each bit with a value of the threshold T subsequently. If an actual quantity of check equations that are not met by a bit is greater than or equal to the threshold T, the bit is an incorrect bit. If an actual quantity of check equations that are not met by a bit is less than the threshold T, the bit is a correct bit.

In addition, the controller chip further needs to calculate the syndrome Si based on the stored data r̂ and the check matrix H. For a manner of obtaining, by the controller chip, the syndrome Si through calculation based on the stored data r̂ and the check matrix H, refer to related descriptions in the foregoing embodiments. Details are not described herein again in this embodiment of this application.

S703: Is the syndrome Si an all-0 value?

If the syndrome Si is the all-0 value, S704 is performed. In this case, decoding is correct, and the stored data r̂ is output. If the syndrome Si is not the all-0 value, S705 is performed.

S705: Is a maximum quantity of iterations reached?

If the maximum quantity of iterations is reached, S706 is performed. In this case, decoding fails, and the decoding process ends. If the maximum quantity of iterations is not reached, S707 is performed.

S707: The controller chip calculates a quantity of check equations that are not met by each bit, and performs bit flipping, where r̂=r̂□1, and □E$_j$≥T; and updates E$_j^1$=d$_{vj}$+1-E$_j$.

After the controller chip determines that the syndrome Si is not the all-0 value, the controller chip needs to calculate the quantity of check equations that are not met by each bit, and compare the quantity of check equations that are not met by each bit with the threshold T. If a quantity of check equations that are not met by a bit is less than the threshold T, the bit is a correct bit. If a quantity of check equations that are not met by a bit is greater than or equal to the threshold T, the bit is an incorrect bit. In this case, the bit needs to be flipped.

During the first iterative operation, the controller chip may calculate, according to Formula (6), the quantity of check equations that are not met by each bit.

$$E_j \triangleq r_j \oplus \hat{r}_j + \sum_{i \in V(j)} s_i + R(lj) \quad \text{Formula (6)}$$

As shown in Formula (6), a difference between Formula (6) and Formula (2) lies in that R(lj) is added to calculate the quantity of check equations that are not met by the bit in Formula (6), where R(lj) is less than or equal to 0, an intermediate variable l$_j$ is used to record a quantity of accumulated iterations affected by bit flipping, and L is a preset value. In some embodiments, R(lj) may also be referred to as a regular term. If a bit j is flipped, l$_j$ = L is updated when the quantity of check equations that are not met by the bit is calculated next time. To be specific, when E$_j$ of the bit is calculated, R(L) is added, and R(L)<0, so that the quantity of check equations that are not met by the bit is decreased. If the bit j is not flipped, l$_j$ = max(l$_j$ - 1,0) is updated when the quantity of check equations that are not met by the bit is calculated next time. Here, 0=R(0)>R(1)≥R(2)≥R(3)...≥R(L).

In some embodiments, a bit error correction algorithm implemented by optimizing the method for calculating the quantity of check equations that are not met by the bit and a parallel operation according to embodiments of this application may be referred to as a regular term bit flipping (Regular Term Bit Flipping, RTBF) algorithm.

For example, L=2.

For example, after a quantity of check equations that are not met by the bit j is calculated for the first time (that is, E$_{j1}$ is obtained), if it is determined that E$_{j1}$ is greater than or equal to a threshold T1, the bit j needs to be flipped. In this case, after the bit j is flipped once, when the quantity of check equations that are not met by the bit is calculated for the second time, in E$_{j2}$, R(lj)=R(L)=R(2), and R(2)<0. If it is determined that E$_{j1}$ is less than the threshold T1, the bit j does not need to be flipped. In this case, when the quantity of check equations that are not met by the bit is calculated for the second time, in E$_{j2}$, R(lj)=R(0), and R(0)=0.

After the quantity of check equations that are not met by the bit j is calculated for the second time (that is, E$_{j2}$ is obtained), when the bit j has been flipped once, if it is determined that E$_{j2}$ is greater than or equal to a threshold T2, the bit j needs to be flipped. In this case, after the bit j is flipped twice, when the quantity of check equations that are not met by the bit is calculated for the third time, in E$_{j3}$, R(lj)=R(L)=R(2), and R(2)<0. If it is determined that E$_{j3}$ is less than the threshold T2, the bit j does not need to be flipped. In this case, when the quantity of check equations that are not met by the bit is calculated for the third time, in E$_{j3}$, R(lj)=R(L-1)=R(1), and 0>R(1)≥R(2).

When the bit j is not flipped, if it is determined that E$_{j2}$ is greater than or equal to the threshold T2, the bit j needs to be flipped. In this case, after the bit j is flipped once, when the quantity of check equations that are not met by the bit is calculated for the third time, in E$_{j3}$, R(lj)=R(L)=R(2), and R(2)<0. If it is determined that E$_{j2}$ is less than the threshold T2, the bit j does not need to be flipped. In this case, when the quantity of check equations that are not met by the bit is calculated for the third time, in E$_{j3}$, R(lj)=R(0)=0.

After the quantity of check equations that are not met by the bit j is calculated for the third time (that is, E$_{j3}$ is obtained), when the bit j has been flipped twice, if it is determined that E$_{j3}$ is greater than or equal to a threshold T3, the bit j needs to be flipped. In this case, after the bit j is flipped for three times, when the quantity of check equations that are not met by the bit is calculated for the fourth time, in E$_{j4}$, R(lj)=R(L)=R(2), and R(2)<0. If it is determined that E$_{j3}$ is less than the threshold T3, the bit j does not need to be flipped. In this case, when the quantity of check equations that are not met by the bit is calculated for the fourth time, in $E_{j4}$, R(lj)=R(L-1)=R(1) , and 0>R(1)≥R(2).

After the bit j is flipped once and is not flipped once, if it is determined that $E_{j3}$ is greater than or equal to the threshold T3, the bit j needs to be flipped. In this case, after the bit j is flipped once again, when the quantity of check equations that are not met by the bit is calculated for the fourth time, in $E_{j4}$, R(lj)=R(L)=R(2), and R(2)<0. If it is determined that $E_{j3}$ is less than the threshold T3, the bit j does not need to be flipped. In this case, after the bit j is not flipped twice consecutively, when the quantity of check equations that are not met by the bit is calculated for the fourth time, in $E_{j4}$, R(lj) =R(1-1)=R(0)=0.

After the quantity of check equations that are not met by the bit j is calculated for the third time (that is, $E_{j3}$ is obtained), after the bit j is not flipped once and is flipped once, if it is determined that $E_{j3}$ is greater than or equal to the threshold T3, the bit j needs to be flipped. In this case, after the bit j is flipped twice consecutively, when the quantity of check equations that are not met by the bit is calculated for the fourth time, in $E_{j4}$, R(lj)=R(L)=R(2), and R(2)<0. If it is determined that $E_{j3}$ is less than the threshold T3, the bit j does not need to be flipped. In this case, when the quantity of check equations that are not met by the bit is calculated for the fourth time, in $E_{j4}$, R(lj)=R(L-1)=R(1) , and 0>R(1)≥R(2).

When the bit j is not flipped, if it is determined that $E_{j3}$ is greater than or equal to the threshold T3, the bit j needs to be flipped. In this case, after the bit j is flipped once, when the quantity of check equations that are not met by the bit is calculated for the fourth time, in $E_{j4}$, R(lj)=R(L)=R(2), and R(2)<0. If it is determined that $E_{j3}$ is less than the threshold T3, the bit j does not need to be flipped. In this case, when the quantity of check equations that are not met by the bit is calculated for the fourth time, in $E_{j4}$, R(lj)=R(0)=0.

It should be noted that, in each iteration process, the threshold T is updated. For details, refer to related descriptions in subsequent embodiments.

If the bit is flipped, $l_j = L$ is updated. If the bit j is flipped, in subsequent L iteration processes, a non-positive number is added based on a quantity, obtained through calculation, of check equations that are not met by the flipped bit, and the quantity of check equations that are not met by the bit j may be decreased. In this case, a possibility that the bit j is flipped repeatedly is also reduced. If the bit is not flipped, $l_j = max(l_j - 1, 0)$ is updated, and $R(lj) = [0 = I(0) > R(1) ≥ \cdots ≥ R(L)]$. In this case, the quantity of check equations that are not met by the bit may be gradually increased, so that a case in which an incorrect bit is not flipped can be avoided.

By analogy, if a current bit is flipped, in subsequent L iteration processes, a value less than 0 is added to a quantity of check equations that are not met by the bit. Therefore, a corresponding $E_j$ of the bit decreases, that is, the quantity of check equations that are not met by the bit also decreases. After bit flipping stops, a value less than 0 is added to the quantity of check equations that are not met by the bit, and the value less than 0 gradually increases until the additional value (or referred to as a regular term) is 0.

It can be learned from the foregoing process that, if a current bit is flipped, in subsequent L iteration processes, a value less than 0 is added to a quantity of check equations that are not met by the bit. Therefore, a corresponding $E_j$ of the bit decreases, that is, the quantity of check equations that are not met by the bit also decreases.

In this way, when the quantity of check equations that are not met by each bit is calculated, if the bit j is flipped, in subsequent L iteration processes, a non-positive number is added based on the quantity, obtained through calculation, of check equations that are not met by the flipped bit, and the quantity of check equations that are not met by the bit j may be decreased. In this case, the possibility that the bit j is flipped repeatedly is also reduced. In this way, the probability that the bit is flipped repeatedly can be reduced, and an effect of finely controlling bit flipping is achieved.

In addition, it can be learned from S702 and S707 that the threshold T is obtained through calculation before the controller chip calculates the quantity of check equations that are not met by each bit. Therefore, the controller chip may simultaneously calculate quantities of check equations that are not met by a plurality of bits, and determine, based on a relationship between the quantities of check equations that are not met by the plurality of bits and the threshold T, whether the plurality of bits need to be flipped. In other words, for a plurality of different bits, a process of calculation of quantities of check equations that are not met by the bits and a bit flipping process may be performed synchronously. Compared with the foregoing embodiments, after separately calculating the quantity of check equations that are not met by each bit, the controller chip does not need to determine to-be-flipped bits based on the quantity of check equations that are not met by each bit, to improve error correction efficiency of the controller chip, reduce a decoding delay, and improve decoding efficiency.

In the first iterative operation, the controller chip obtains, according to Formula (6), the quantity of check equations that are not met by each bit. If a quantity of check equations that are not met by a bit is greater than or equal to the threshold T1, the controller chip flips the bit according to Formula r̂=r̂□1, to obtain a flipped bit sequence.

After the flipped bit sequence is obtained, the quantity of check equations that are not met by each bit also changes. Therefore, the controller chip needs to update the quantity of check equations that are not met by each bit after flipping, so that the threshold T can be updated subsequently.

After the first iterative operation is performed, the controller chip may update, according to Formula (7), the quantity of check equations that are not met by each bit, that is, update the quantity of check equations that are not met by each bit after flipping.

$$E_j{}^1 = d_{vj} + 1 - E_j \quad \text{Formula (7)}$$

As shown in Formula (4), $E_j{}^1$ indicates the quantity of check equations that are not met by each bit after flipping, and $E_j$ indicates a quantity of check equations that are not met by each bit before flipping. The controller chip may obtain, based on the quantity of check equations that are not met by each bit before flipping and the maximum degree of each bit, the quantity of check equations that are not met by each bit after flipping. It should be noted that, Formula (7) is used by the controller chip to obtain, through estimation, the quantity of check equations that are not met by each bit after flipping, so that the controller chip can update the threshold T.

S708: The controller chip updates the threshold T, where $T2 = \max\{\max E_j, \max E_j{}^1\}$.

A quantity of check equations that are not met by the $j^{th}$ bit after bit flipping may be greater than or equal to a quantity of check equations that are not met by the $j^{th}$ bit before bit flipping. Therefore, the controller chip needs to find a largest value from the quantity of check equations that are not met by each bit before bit flipping and the quantity of check equations that are not met by each bit after bit flipping, and use the largest value as an updated value of the threshold T, namely, the threshold T2, where the threshold $T2 = \max\{\max E_j, \max E_j{}^1\}$.

After the controller chip updates the threshold T to obtain the threshold T2, the controller chip continues to perform S702. In a second iteration process, the controller chip only needs to calculate the syndrome Si based on bit data and a check matrix H that are obtained through flipping. The threshold T2 does not need to be determined based on the check matrix H, and the threshold T2 has been calculated after bit flipping.

For a subsequent error correction process, refer to the foregoing descriptions in S703 to S707. A correct decoding result is output until the syndrome is an all-0 value. Alternatively, when a maximum quantity of iterations is reached, decoding fails in this case.

Optionally, in some embodiments, the controller chip may further perform S709, and S709 includes the following content.

The controller chip limits a flipping probability of a bit that meets a flipping condition based on a random sequence generator. A main function is to further alleviate repeated flipping of a same bit, to effectively reduce an error floor.

Specifically, the controller chip generates a 0-1 sequence based on the random sequence generator and a preset probability value p, where the probability p is a probability that 0 occurs in the 0-1 sequence. When the random sequence generator outputs 0, the bit that meets the flipping condition is not flipped. When the random sequence generator outputs 1, the bit that meets the flipping condition is flipped. A quantity of elements 0 and a quantity of elements 1 in the 0-1 sequence are the same as a quantity of pieces of bit data that meets the flipping condition.

For example, there are 10 bits in total in the bit sequence. The controller chip determines that a $0^{th}$ bit, a $3^{rd}$ bit, a $4^{th}$ bit, a $5^{th}$ bit, a $7^{th}$ bit, and a $9^{th}$ bit in the 10 bits meet the flipping condition, that is, 6 bits in total meet the flipping condition. The controller chip determines, based on the random sequence generator and a preset probability value (for example, 50%), that only 3 bits in the 6 bits need to be flipped. The random sequence generator generates 6 digital sequences including 0 and 1. In the 6 digital sequences including 0 and 1, a quantity of elements 0 included is 3, and a quantity of elements 1 included is also 3. When the random sequence generator outputs an element 0, the controller chip controls a bit that currently meets the flipping condition not to be flipped. When the random sequence generator outputs an element 1, the controller chip controls a bit that currently meets the flipping condition to be flipped.

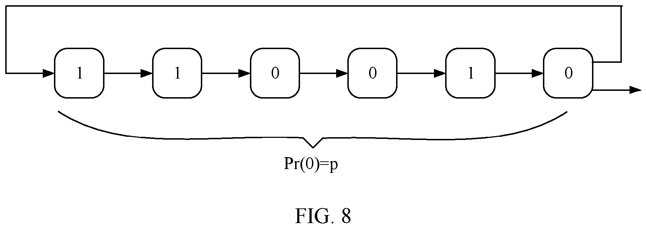

As shown in FIG. 8, FIG. 8 is an example of a diagram of a 0-1 digital sequence generated by a random sequence generator.

As shown in FIG. 8, when the random sequence generator outputs a first 0, a controller chip controls a $0^{th}$ bit that meets a flipping condition not to be flipped. When the random sequence generator outputs a first 1, the controller chip controls a $3^{rd}$ bit that meets the flipping condition to be flipped. When the random sequence generator outputs a second 0, the controller chip controls a $4^{th}$ bit that meets the flipping condition not to be flipped. When the random sequence generator outputs a third 0, the controller chip controls a $5^{th}$ bit that meets the flipping condition not to be flipped. When the random sequence generator outputs a second 1, the controller chip controls a $7^{th}$ bit that meets the flipping condition to be flipped. When the random sequence generator outputs a third 1, the controller chip controls a $9^{th}$ bit that meets the flipping condition to be flipped.

In this manner, the controller chip may control a quantity of bits that meet the flipping condition and that are flipped. Impact of a trapping set is reduced based on the random sequence generator, and a hardware-friendly generator is implemented by using a 0-1 proportion sequence.

In some embodiments, a probabilistic flipping algorithm provided according to an RTBF algorithm in embodiments of this application may be referred to as a regular term probabilistic bit flipping (Regular Term Probabilistic Bit Flipping, RTPBF) algorithm.

This embodiment of this application provides a first-stage decoding solution of an SSD controller chip. A method for calculating a quantity of check equations that are not met by a bit, a parallel operation, and a random flipping mechanism are optimized, to effectively improve an error correction capability of bit flipping decoding and a throughput of the overall solution, and prolong a service life of an SSD storage device.

Table 1 compares error correction capabilities of a GDBF algorithm, the RTPF algorithm, and the RTPBF algorithm at different RBERs.

**Table 1**

| RBER | 0.005 | 0.0045 | 0.004 | 0.0035 | 0.003 | 0.0025 | 0.002 |
|------|-------|--------|-------|--------|-------|--------|-------|
| GDBF | 5.39E-06 | 9.37E-07 | 1.08E-07 | 1.05E-08 | 4.81E-09 | 1.60E-09 | 5.62E-10 |
| RTBF | 5.90E-06 | 1.15E-06 | 7.20E-08 | 1.88E-09 | 2.74E-11 | 3.49E-12 | 1.32E-12 |
| RTPBF | 5.90E-06 | 1.11E-06 | 6.71E-08 | 2.04E-09 | 1.50E-11 | 9.60E-13 | 1.80E-13 |

As shown in Table 1, an obvious error floor (Error Floor) phenomenon occurs in the existing GDBF algorithm as an RBER decreases. The RTBF algorithm and the RTPBF algorithm proposed in this application respectively reduce an error floor of two orders of magnitude (a factor of 100) and an error floor of three orders of magnitude (a factor of 1000) when the RBER=0.002, to reduce cases in which a controller chip enters a second/third-stage decoding phase with a longer delay.

Table 2 compares average quantities of iterations of error correction in the GDBF algorithm, the RTPF algorithm, and the RTPBF algorithm at different RBERs.

Table 2

| RBER | 0.005 | 0.0045 | 0.004 | 0.0035 | 0.003 | 0.0025 | 0.002 |
|------|-------|--------|-------|--------|-------|--------|-------|
| GDBF | 23.64 | 15.73 | 11.57 | 8.97 | 7.17 | 5.806 | 4.689 |
| RTBF | 23.33 | 15.295 | 11.054 | 8.781 | 7.285 | 6.128 | 5.023 |
| RTPBF | 23.38 | 15.302 | 11.053 | 8.782 | 7.284 | 6.128 | 5.015 |

Table 2 compares the average quantities of iterations of error correction in the GDBF algorithm, the RTPF algorithm, and the RTPBF algorithm at the different RBERs. In this application, calculation of a quantity of check equations that are not met by a bit and parallel processing of bit flipping are performed. Therefore, an overall throughput can be doubled.

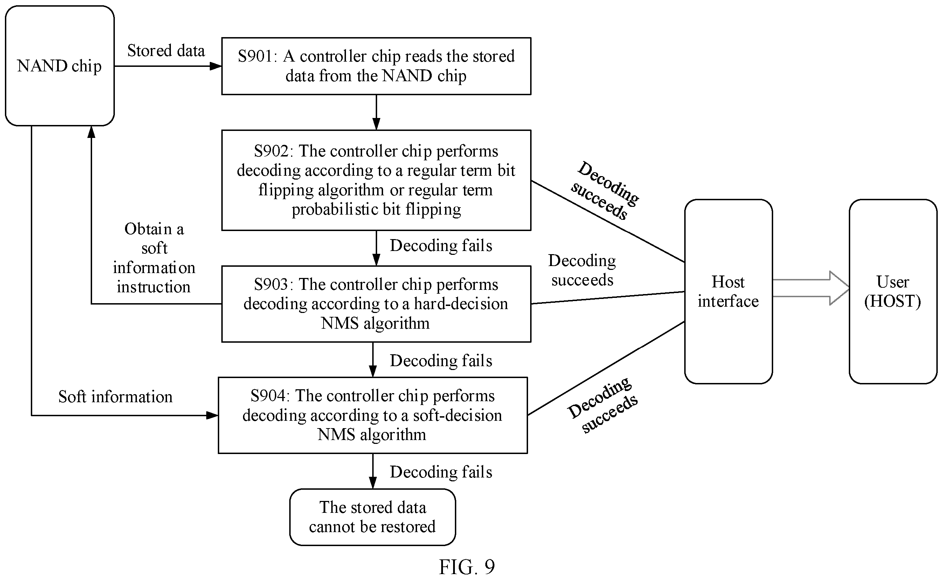

An LDPC code with a quasi-cyclic block size of 256 is usually used in a commercial SSD device. The LDPC code has a code length of 18944, an information dimension of 17152, and a bit rate of 0.905. To meet requirements of a throughput and a service life of a product, embodiments of the present invention use a three-stage decoding structure, as shown in FIG. 9. At an initial stage of using a NAND chip, an error rate RBER of data reading is low, and the controller chip starts RTBF decoding in the technical solutions of the present invention, to provide a high-speed data reading function for a user. As a quantity of read/write times and use time of the NAND chip increase, the error rate of data reading increases, and an RTBF decoding failure rate increases. In this case, the controller chip starts second-stage decoding, namely, hard-decision NMS decoding. Because second-stage decoding does not need to read soft information, second-stage decoding provides a balance between an error correction capability and a decoding delay. If second-stage decoding fails, the controller chip needs to read soft information from the NAND chip and perform first two-stage decoding again. If two-stage decoding fails again, soft-decision NMS decoding is started to use a more precise and complex algorithm to correct an error and restore data to the user. However, a corresponding decoding delay is prolonged. Last-stage decoding is mainly used to ensure a service life of the SSD device.

FIG. 9 is a diagram of another method of a multi-stage decoding algorithm according to an embodiment of this application.

For example, the multi-stage decoding algorithm may be: A first-stage decoding algorithm is an RTBF algorithm, a second-stage decoding algorithm is a hard-decision NMS algorithm, and a third-stage decoding algorithm is a soft-decision NMS decoding algorithm.

S901: A controller chip reads stored data from a NAND chip.

S902: The controller chip performs decoding according to a regular term bit flipping algorithm or regular term probabilistic bit flipping.

The controller chip performs decoding according to the RTBF algorithm or the RTPBF algorithm, and after decoding succeeds, the controller chip outputs correct stored data, that is, transmits stored data obtained through decoding to a host through a host interface. Decoding ends.

If the controller chip fails to perform decoding according to the RTBF algorithm or the RTPBF algorithm, the controller chip performs a next-stage decoding algorithm.

S903: The controller chip performs decoding according to the hard-decision NMS algorithm.

The hard-decision NMS algorithm and the RTBF algorithm or the RTPBF algorithm use the same data for decoding. The hard-decision NMS algorithm and the RTBF algorithm or the RTPBF algorithm use data for decoding different from that used by the soft-decision NMS algorithm.

The controller chip performs decoding according to the hard-decision NMS algorithm, and after decoding succeeds, the controller chip outputs correct stored data, that is, transmits the stored data obtained through decoding to a host through a host interface. Decoding ends.

If the controller chip fails to perform decoding according to the hard-decision NMS algorithm, the controller chip performs a next-stage decoding algorithm. In addition, the hard-decision NMS algorithm is used to send a soft information reading instruction to the NAND chip.

S904: After obtaining soft information from the NAND chip, the controller chip performs decoding according to the soft-decision NMS algorithm.

The controller chip performs decoding according to the soft-decision NMS algorithm, and after decoding succeeds, the controller chip outputs correct stored data, that is, transmits the stored data obtained through decoding to a host through a host interface. Decoding ends.

If the controller chip fails to perform decoding according to the soft-decision NMS algorithm, decoding ends, and the controller chip cannot restore correct stored data.

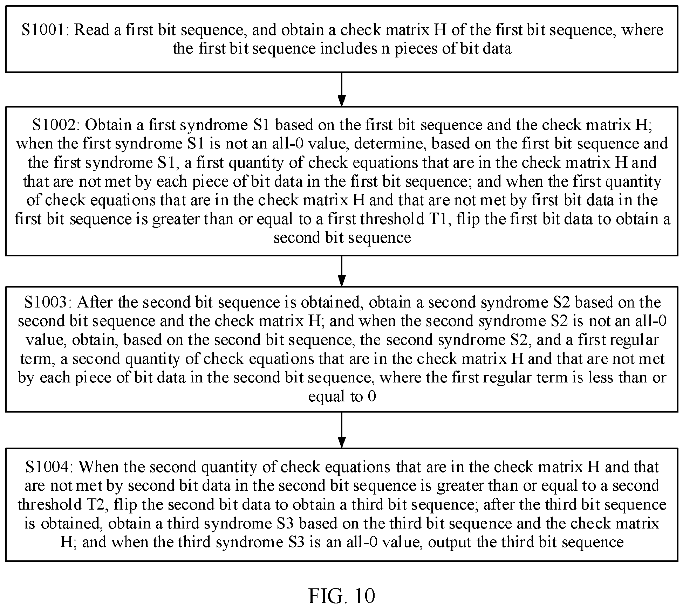

FIG. 10 is a diagram of a decoding method according to an embodiment of this application.

S1001: Read a first bit sequence, and obtain a check matrix H of the first bit sequence, where the first bit sequence includes n pieces of bit data.

S1002: Obtain a first syndrome S1 based on the first bit sequence and the check matrix H; when the first syndrome S1 is not an all-0 value, determine, based on the first bit sequence and the first syndrome S1, a first quantity of check equations that are in the check matrix H and that are not met by each piece of bit data in the first bit sequence; and when the first quantity of check equations that are in the check matrix H and that are not met by first bit data in the first bit sequence is greater than or equal to a first threshold T1, flip the first bit data to obtain a second bit sequence.

In a possible implementation, when the first bit data is flipped, the method further includes: when the first quantity of check equations that are in the check matrix H and that are not met by fourth bit data in the first bit sequence is greater than or equal to the first threshold T1, flipping the fourth bit data to obtain the second bit sequence. In this way, a threshold determining mechanism is introduced, so that the controller chip can simultaneously perform calculation of a quantity of check equations that are not met by a bit and a bit flipping process, to reduce a decoding delay of the controller chip and increase a decoding throughput.

In a possible implementation, the first threshold T1 is determined based on the check matrix H.

In a possible implementation, the flipping the first bit data specifically includes: obtaining a first digital sequence based on a first probability value and a first random sequence generator, where a quantity of elements included in the first digital sequence is the same as a quantity of pieces of flipped bit data in the first bit sequence, a value of an element in the first digital sequence is 0 or 1, and a proportion of elements whose values are 1 in the first digital sequence is the first probability value; and flipping the first bit data when a value of an element corresponding to a location that is in the first digital sequence and that corresponds to a location of the first bit data in the first bit sequence is 1. The random sequence generator is proposed to limit a flipping probability of a bit that meets a flipping condition. This reduces occurrences of a case in which a same bit falls into an infinite cycle due to repeated flipping. The decoding delay of the controller chip is reduced, and the decoding throughput is increased.

In a possible implementation, the first bit sequence is output when the first syndrome S1 is an all-0 value.

S1003: After the second bit sequence is obtained, obtain a second syndrome S2 based on the second bit sequence and the check matrix H; and when the second syndrome S2 is not an all-0 value, obtain, based on the second bit sequence, the second syndrome S2, and a first regular term, a second quantity of check equations that are in the check matrix H and that are not met by each piece of bit data in the second bit sequence, where the first regular term is less than or equal to 0.

In a possible implementation, the first regular term is less than 0 when a location of the first bit data in the first bit sequence is the same as a location of second bit data in the second bit sequence. In this way, an algorithm for calculating, by the controller chip, a quantity of check equations that are not met by each bit is optimized, to reduce a probability that a correct bit is incorrectly flipped, so as to reduce an error floor of decoding.

Optionally, the first regular term is equal to 0 when the location of the first bit data in the first bit sequence is different from the location of the second bit data in the second bit sequence.

In a possible implementation, the second bit sequence is output when the second syndrome S2 is an all-0 value.

S1004: When the second quantity of check equations that are in the check matrix H and that are not met by the second bit data in the second bit sequence is greater than or equal to a second threshold T2, flip the second bit data to obtain a third bit sequence; after the third bit sequence is obtained, obtain a third syndrome S3 based on the third bit sequence and the check matrix H; and when the third syndrome S3 is an all-0 value, output the third bit sequence.

In a possible implementation, after the second bit sequence is obtained, and before the second bit data is flipped, the method further includes: obtaining, based on the first quantity of check equations that are in the check matrix H and that are not met by each piece of bit data and a preset maximum quantity of check equations that are in the check matrix H and that are not met by each piece of bit data, a fourth quantity of check equations that are in the check matrix H and that are not met by each piece of bit data; and determining, by the chip, that a largest value of the first quantity of check equations that are in the check matrix H and that are not met by each piece of bit data and the fourth quantity of check equations that are in the check matrix H and that are not met by each piece of bit data is the second threshold T2. In this way, a threshold T needs to be updated after flipping is performed each time.

In a possible implementation, the fourth quantity of check equations that are in the check matrix H and that are not met by each piece of bit data is determined based on $E_j^1 = d_{vj} + 1 - E_j$, where $E_j^1$ indicates the fourth quantity of check equations that are in the check matrix H and that are not met by each piece of bit data, $d_{vj}$ indicates the preset maximum quantity of check equations that are in the check matrix H and that are not met by each piece of bit data, and $E_j$ indicates the first quantity of check equations that are in the check matrix H and that are not met by each piece of bit data.

In a possible implementation, the method further includes: when the third syndrome S3 is not the all-0 value, obtaining, based on the third bit sequence, the second syndrome S2, and a second regular term, a third quantity of check equations that are in the check matrix H and that are not met by each piece of bit data in the third bit sequence, where the second regular term is less than or equal to 0; when the third quantity of check equations that are in the check matrix H and that are not met by third bit data in the third bit sequence is greater than or equal to a third threshold T3, flipping the third bit data to obtain a fourth bit sequence; after the fourth bit sequence is obtained, obtaining a fourth syndrome S4 based on the fourth bit sequence and the check matrix H; and when the third syndrome S4 is an all-0 value, outputting the third bit sequence. In this way, the foregoing process is repeated until the syndrome is an all-0 value or a maximum quantity of iterations is reached.

In a possible implementation, when a location of the first bit data in the first bit sequence, a location of the second bit data in the second bit sequence, and a location of the third bit data in the third bit sequence are the same, the second regular term is equal to the first regular term, and the second regular term is less than 0. In this way, if a same piece of bit data is continuously flipped, when a quantity of check equations that are not met by the bit data is calculated, a regular term less than 0 is added, to reduce a probability of the bit data being repeatedly flipped.

In a possible implementation, a value of the second regular term is 0 when the location of the second bit data in the second bit sequence is different from the location of the third bit data in the third bit sequence.

In this way, the foregoing process is repeated until the syndrome is an all-0 value or a maximum quantity of iterations is reached.

According to the method in the first aspect, an algorithm for calculating, by the controller chip, a quantity of check equations that are not met by each bit is optimized, to reduce a probability that a correct bit is incorrectly flipped, so as to reduce an error floor of decoding. In addition, a threshold determining mechanism is introduced, so that the controller chip can simultaneously perform calculation of a quantity of check equations that are not met by a bit and a bit flipping process, to reduce a decoding delay of the controller chip and increase a decoding throughput. In addition, a random sequence generator is proposed to limit a flipping probability of a bit that meets a flipping condition. This reduces occurrences of a case in which a same bit falls into an infinite cycle due to repeated flipping. The decoding delay of the controller chip is reduced, and the decoding throughput is increased.

This application further provides a chip. The chip includes a processing circuit and an interface circuit. The interface circuit is configured to receive code instructions and transmit the code instructions to the processing circuit. The processing circuit is configured to run the code instructions to perform the decoding method according to embodiments in FIG. 10.

This application further provides a decoding apparatus. The decoding apparatus includes a chip and a memory. The memory is configured to store a first bit sequence. The chip is configured to read the first bit sequence from the memory, to perform the decoding method according to embodiments in FIG. 10.

This application further provides a computer-readable storage medium. The computer-readable storage medium stores instructions. When the instructions are run on a chip, the chip is enabled to perform the decoding method according to embodiments in FIG. 10.

This application further provides a computer program product. When the computer program product is executed by a chip, the chip is enabled to perform the decoding method according to embodiments in FIG. 10.

The implementations of this application may be randomly combined to achieve different technical effect.

All or some of the foregoing embodiments may be implemented by using software, hardware, firmware, or any combination thereof. When software is used to implement the foregoing embodiments, all or some of embodiments may be implemented in a form of a computer program product. The computer program product includes one or more computer instructions. When the computer program instructions are loaded and executed on a computer, procedures or functions according to this application are all or partially generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

Persons of ordinary skill in the art may understand that all or some of the procedures of the methods in embodiments may be implemented by a computer program instructing relevant hardware. The program may be stored in a computer-readable storage medium. When the program runs, the procedures of the method embodiments may be included. The foregoing storage medium includes any medium that can store program code, such as a ROM, a random access memory RAM, a magnetic disk, or an optical disc.

In conclusion, the foregoing descriptions are merely embodiments of the technical solutions of the present invention, but are not intended to limit the protection scope of the present invention. Any modification, equivalent replacement, improvement, or the like made according to the disclosure of the present invention shall fall within the protection scope of the present invention.

**Claims**

1.  A decoding method, wherein the method comprises:

    reading a first bit sequence, and obtaining a check matrix H of the first bit sequence, wherein the first bit sequence comprises n pieces of bit data;
    obtaining a first syndrome S1 based on the first bit sequence and the check matrix H;
    when the first syndrome S1 is not an all-0 value, determining, based on the first bit sequence and the first syndrome S1, a first quantity of check equations that are in the check matrix H and that are not met by each piece of bit data in the first bit sequence;
    when the first quantity of check equations that are in the check matrix H and that are not met by first bit data in the first bit sequence is greater than or equal to a first threshold T1, flipping the first bit data to obtain a second bit sequence;
    after the second bit sequence is obtained, obtaining a second syndrome S2 based on the second bit sequence and the check matrix H;
    when the second syndrome S2 is not an all-0 value, obtaining, based on the second bit sequence, the second syndrome S2, and a first regular term, a second quantity of check equations that are in the check matrix H and that are not met by each piece of bit data in the second bit sequence, wherein the first regular term is less than or equal to 0;
    when the second quantity of check equations that are in the check matrix H and that are not met by second bit data in the second bit sequence is greater than or equal to a first threshold T2, flipping the second bit data to obtain a third bit sequence;
    after the third bit sequence is obtained, obtaining a third syndrome S3 based on the third bit sequence and the check matrix H; and
    when the third syndrome S3 is an all-0 value, outputting the third bit sequence.

2.  The method according to claim 1, wherein the method further comprises:

    when the third syndrome S3 is not an all-0 value, obtaining, based on the third bit sequence, the second syndrome S2, and a second regular term, a third quantity of check equations that are in the check matrix H and that are not met by each piece of bit data in the third bit sequence, wherein the second regular term is less than or equal to 0;
    when the third quantity of check equations that are in the check matrix H and that are not met by third bit data in the third bit sequence is greater than or equal to a third threshold T3, flipping the third bit data to obtain a fourth bit sequence;
    after the fourth bit sequence is obtained, obtaining a fourth syndrome S4 based on the fourth bit sequence and the check matrix H; and
    when the third syndrome S4 is an all-0 value, outputting the third bit sequence.

3.  The method according to claim 1 or 2, wherein the first regular term is less than 0 when a location of the first bit data in the first bit sequence is the same as a location of the second bit data in the second bit sequence.

# EP 4 538 890 A1

4. The method according to claim 2, wherein when a location of the first bit data in the first bit sequence, a location of the second bit data in the second bit sequence, and a location of the third bit data in the third bit sequence are the same, the second regular term is equal to the first regular term, and the second regular term is less than 0.

5. The method according to claim 2 or 4, wherein a value of the second regular term is 0 when the location of the second bit data in the second bit sequence is different from the location of the third bit data in the third bit sequence.

6. The method according to any one of claims 1 to 5, wherein when the first bit data is flipped, the method further comprises:
   when the first quantity of check equations that are in the check matrix H and that are not met by fourth bit data in the first bit sequence is greater than or equal to the first threshold T1, flipping the fourth bit data to obtain the second bit sequence.

7. The method according to any one of claims 1 to 6, wherein the first threshold T1 is determined based on the check matrix H.

8. The method according to any one of claims 1 to 6, wherein after the second bit sequence is obtained and before the second bit data is flipped, the method further comprises:

   obtaining, based on the first quantity of check equations that are in the check matrix H and that are not met by each piece of bit data and a preset maximum quantity of check equations that are in the check matrix H and that are not met by each piece of bit data, a fourth quantity of check equations that are in the check matrix H and that are not met by each piece of bit data; and
   determining, by a chip, that a largest value of the first quantity of check equations that are in the check matrix H and that are not met by each piece of bit data and the fourth quantity of check equations that are in the check matrix H and that are not met by each piece of bit data is the second threshold T2.

9. The method according to claim 8, wherein the fourth quantity of check equations that are in the check matrix H and that are not met by each piece of bit data is determined based on $E_j^1 = d_{vj} + 1 - E_j$, wherein $E_j^1$ indicates the fourth quantity of check equations that are in the check matrix H and that are not met by each piece of bit data, $d_{vj}$ indicates the preset maximum quantity of check equations that are in the check matrix H and that are not met by each piece of bit data, and $E_j$ indicates the first quantity of check equations that are in the check matrix H and that are not met by each piece of bit data.

10. The method according to any one of claims 1 to 9, wherein the flipping the first bit data specifically comprises:

    obtaining a first digital sequence based on a first probability value and a first random sequence generator, wherein a quantity of elements comprised in the first digital sequence is the same as a quantity of pieces of flipped bit data in the first bit sequence, a value of an element in the first digital sequence is 0 or 1, and a proportion of elements whose values are 1 in the first digital sequence is the first probability value; and
    flipping the first bit data when a value of an element corresponding to a location that is in the first digital sequence and that corresponds to a location of the first bit data in the first bit sequence is 1.

11. The method according to any one of claims 1 to 10, wherein the first bit sequence is output when the first syndrome S1 is an all-0 value.

12. The method according to claims 1 to 11, wherein the second bit sequence is output when the second syndrome S2 is an all-0 value.

13. A chip, wherein the chip comprises a processing circuit and an interface circuit, the interface circuit is configured to receive code instructions and transmit the code instructions to the processing circuit, and the processing circuit is configured to run the code instructions to perform the method according to any one of claims 1 to 12.

14. A decoding apparatus, wherein the decoding apparatus comprises a chip and a memory, the memory is configured to store a first bit sequence, and the chip is configured to read the first bit sequence from the memory, to perform the method according to any one of claims 1 to 12.

15. A computer-readable storage medium, wherein the computer-readable storage medium stores instructions, and

18

when the instructions are run on a chip, the chip is enabled to perform the method according to any one of claims 1 to 12.

16. A computer program product, wherein when the computer program product is executed by a chip, the chip is enabled to perform the method according to any one of claims 1 to 12.

S101: A controller chip reads stored data from a NAND chip

S102: The controller chip performs decoding according to a bit flipping decoding algorithm

*Decoding succeeds*

Decoding fails

S103: The controller chip performs decoding according to a hard-decision NMS decoding algorithm

Decoding succeeds

Obtain correct stored data

Decoding fails

S104: The controller chip performs decoding according to a soft-decision NMS decoding algorithm

*Decoding succeeds*

Decoding fails

The stored data cannot be restored

FIG. 1

S201: A controller chip reads stored data r from a
NAND chip

S202: The controller chip calculates a syndrome $S_i$
based on the stored data r and a check matrix H

S203: Is the syndrome
$S_i$ an all-0 value?

Yes

S204: In this case,
decoding is correct,
and the stored data r
is output

No

S205: Is a maximum
quantity of iterations
reached?

Yes

S206: Decoding fails

No

S207: The controller chip calculates a quantity of
check equations that are not met by each bit, and
determines a bit that does not meet a largest
quantity of check equations

S208: The controller chip flips the bit that does not
meet the largest quantity of check equations

FIG. 2

FIG. 3

FIG. 4

FIG. 5

FIG. 6

S701: A controller chip reads stored data r from a NAND chip, and it is assumed that $\hat{r} = r$

S702: The controller chip calculates a syndrome $S_i$ based on the stored data $\hat{r}$ and a check matrix H, and determines a threshold T based on the check matrix

S703: Is the syndrome $S_i$ an all-0 value?

Yes → S704: In this case, decoding is correct, and the stored data $\hat{r}$ is output

No

S705: Is a maximum quantity of iterations reached?

Yes → S706: Decoding fails

No

S707: The controller chip calculates a quantity of check equations that are not met by each bit, and performs bit flipping, where $\hat{r} = \hat{r} \oplus 1$, and $\forall E_j \geq T$; and updates $E_j^1 = d_{vj} + 1 - E_j$

S709: Random sequence generator

S708: Update the threshold T, where $T2 = \max\{\max E_j, \max E_j^1\}$

FIG. 7

Pr(0)=p

FIG. 8

NAND chip

Stored data → S901: A controller chip reads the stored data from the NAND chip

S902: The controller chip performs decoding according to a regular term bit flipping algorithm or regular term probabilistic bit flipping

*Decoding succeeds*

Decoding fails

Obtain a soft information instruction

S903: The controller chip performs decoding according to a hard-decision NMS algorithm

Decoding succeeds

Decoding fails

Soft information

S904: The controller chip performs decoding according to a soft-decision NMS algorithm

*Decoding succeeds*

Decoding fails

The stored data cannot be restored

Host interface → User (HOST)

FIG. 9

S1001: Read a first bit sequence, and obtain a check matrix H of the first bit sequence, where the first bit sequence includes n pieces of bit data

S1002: Obtain a first syndrome S1 based on the first bit sequence and the check matrix H; when the first syndrome S1 is not an all-0 value, determine, based on the first bit sequence and the first syndrome S1, a first quantity of check equations that are in the check matrix H and that are not met by each piece of bit data in the first bit sequence; and when the first quantity of check equations that are in the check matrix H and that are not met by first bit data in the first bit sequence is greater than or equal to a first threshold T1, flip the first bit data to obtain a second bit sequence

S1003: After the second bit sequence is obtained, obtain a second syndrome S2 based on the second bit sequence and the check matrix H; and when the second syndrome S2 is not an all-0 value, obtain, based on the second bit sequence, the second syndrome S2, and a first regular term, a second quantity of check equations that are in the check matrix H and that are not met by each piece of bit data in the second bit sequence, where the first regular term is less than or equal to 0

S1004: When the second quantity of check equations that are in the check matrix H and that are not met by second bit data in the second bit sequence is greater than or equal to a second threshold T2, flip the second bit data to obtain a third bit sequence; after the third bit sequence is obtained, obtain a third syndrome S3 based on the third bit sequence and the check matrix H; and when the third syndrome S3 is an all-0 value, output the third bit sequence

FIG. 10

## INTERNATIONAL SEARCH REPORT

| International application No. |
|---|
| **PCT/CN2023/098056** |

### A. CLASSIFICATION OF SUBJECT MATTER

G06F 11/10(2006.01)i; H03M13/11(2006.01)i

According to International Patent Classification (IPC) or to both national classification and IPC

### B. FIELDS SEARCHED

Minimum documentation searched (classification system followed by classification symbols)

G06F11/-, H03M13/-

Documentation searched other than minimum documentation to the extent that such documents are included in the fields searched

Electronic data base consulted during the international search (name of data base and, where practicable, search terms used)

CJFD, CNTXT, DWPI, ENTXT, ENTXTC, VEN, WPABS, WPABSC, CNKI, 互联网, Internet: 比特, 变小, 不满足, 翻转, 反复, 加, 减少, 减小, 解码, 数量, 死循环, 下一次, 小于0, 校验方程, 译码, 正则, 重复, 重复翻转, 阈值, bit, method, regular, repeat+, flip+, decod+, threshold, RTBF, less than zero, next time

### C. DOCUMENTS CONSIDERED TO BE RELEVANT

| Category* | Citation of document, with indication, where appropriate, of the relevant passages | Relevant to claim No. |
|---|---|---|
| A | CN 103888148 A (SHANDONG SINOCHIP SEMICONDUCTORS CO., LTD.) 25 June 2014 (2014-06-25)<br>description, paragraphs [0037]-[0071] | 1-16 |
| A | CN 109560819 A (NANJING UNIVERSITY) 02 April 2019 (2019-04-02)<br>entire document | 1-16 |
| A | CN 103281090 A (SOUTH CHINA UNIVERSITY OF TECHNOLOGY) 04 September 2013 (2013-09-04)<br>entire document | 1-16 |
| A | CN 103684476 A (MARVELL WORLD TRADE LTD.) 26 March 2014 (2014-03-26)<br>entire document | 1-16 |
| A | CN 110572164 A (SHENZHEN UNION MEMORY INFORMATION SYSTEM CO., LTD.) 13 December 2019 (2019-12-13)<br>entire document | 1-16 |
| A | EP 3540949 A1 (UNIVERSITÉ BRETAGNE SUD et al.) 18 September 2019 (2019-09-18)<br>entire document | 1-16 |

☑ Further documents are listed in the continuation of Box C.    ☑ See patent family annex.

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 July 2023** | **28 July 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/098056** |

**C.  DOCUMENTS CONSIDERED TO BE RELEVANT**

| Category* | Citation of document, with indication, where appropriate, of the relevant passages | Relevant to claim No. |
|---|---|---|
| A | US 2015358036 A1 (PHISON ELECTRONICS CORP.) 10 December 2015 (2015-12-10)<br>entire document | 1-16 |
| A | 刘冰 等 (LIU, Bing et al.). "LDPC码混合加权比特翻转译码算法 (Non-official translation: LDPC Code Hybrid Weighted Bit Flip Decoding Algorithm)"<br>系统工程与电子技术 *(Systems Engineering and Electronics),*<br>Vol. vol. 32, No. 10, 15 October 2010 (2010-10-15), 2252-2256<br>text, sections 1-3 | 1-16 |

Form PCT/ISA/210 (second sheet) (July 2022)

## INTERNATIONAL SEARCH REPORT
### Information on patent family members

International application No.

**PCT/CN2023/098056**

| Patent document cited in search report | | | Publication date (day/month/year) | Patent family member(s) | | | Publication date (day/month/year) |
|---|---|---|---|---|---|---|---|
| CN | 103888148 | A | 25 June 2014 | WO | 2015139160 | A1 | 24 September 2015 |
| | | | | CN | 103888148 | B | 26 October 2016 |
| CN | 109560819 | A | 02 April 2019 | | None | | |
| CN | 103281090 | A | 04 September 2013 | CN | 103281090 | B | 22 February 2017 |
| CN | 103684476 | A | 26 March 2014 | US | 2014068393 | A1 | 06 March 2014 |
| | | | | US | 9203432 | B2 | 01 December 2015 |
| | | | | CN | 103684476 | B | 09 October 2018 |
| CN | 110572164 | A | 13 December 2019 | CN | 110572164 | B | 10 February 2023 |
| EP | 3540949 | A1 | 18 September 2019 | | None | | |
| US | 2015358036 | A1 | 10 December 2015 | US | 9543983 | B2 | 10 January 2017 |
| | | | | TW | 201546815 | A | 16 December 2015 |
| | | | | TWI | 543178 | B | 21 July 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210723134